## Europäisches Patentamt
## European Patent Office
## Office européen des brevets

(19)

(11) Numéro de publication: **0 050 064**
**B1**

(12)

# FASCICULE DE BREVET EUROPEEN

(45) Date de publication du fascicule du brevet:
02.05.85

(21) Numéro de dépôt: 81401484.1

(22) Date de dépôt: 24.09.81

(51) Int. Cl.⁴: **H 01 L 29/80,** H 01 L 29/62,
H 01 L 29/10

(54) **Transistor à effet de champ à fréquence de coupure élevée.**

(30) Priorité: 14.10.80 FR 8021942

(43) Date de publication de la demande:
21.04.82 Bulletin 82/16

(45) Mention de la délivrance du brevet:
02.05.85 Bulletin 85/18

(84) Etats contractants désignés:
DE GB IT NL

(73) Titulaire: **THOMSON-CSF, 173, Boulevard Haussmann,
F-75379 Paris Cedex 08 (FR)**

(72) Inventeur: **Nuyen, Tronglinh, THOMSON-CSF
SCPI 173, bld Haussmann, F-75360 Paris Cedex 08 (FR)**
Inventeur: **Delagebeaudeuf, Daniel, THOMSON-CSF
SCPI 173, bld Haussmann, F-75360 Paris Cedex 08 (FR)**

(74) Mandataire: **Taboureau, James et al, THOMSON-CSF
SCPI 173, Bld Haussmann, F-75379 Paris Cedex 08 (FR)**

(56) Documents cités:
EP - A - 0 005 059
EP - A - 0 025 742
EP - A - 0 033 037
US - A - 4 160 261

IEEE ELECTRON DEVICE LETTERS, vol. EDL-1, no. 9,
septembre 1980, IEEE New York, US J. BARNARD et al.
"Double heterostructure Ga0.47In 0.53As MESFETs with
sub-micron gates", pages 174-1976
IEEE LECTRON DEVICE LETTERS, vol. EDL-1, no. 8,
août 1980 IEEE New York, US H. OHNO et al. "Double
hetero-structure Ga0.47In0.53As MESFETs by MBE",
pages 154-155
ELECTRONICS LETTERS, vol. 16, no. 17 août 1980
Hitchin-Herts, GB D. DELAGE BEAUDEUF et al.
"Two-dimensional electron gas MESFET structure",

(56) Documents cités: (suite)
pages 667-668
IEEE TRANSACTIONS ON ELECTRON DEVICES, vol.
ED-27, no. 7 juillet 1980 IEEE New York, US J.M. GOLIO
et al. "Compound semiconductors for low-noice
microwave MESFET applications", pages 1265-1262

## Description

La présente invention concerne les transistors à effet de champ, et plus particulièrement ceux dont la fréquence de coupure est élevée.

Parmi les transistors à effet de champ connus, de la famille des semiconducteurs III–V, ont été décrits des transistors comportant, supportées par un substrat semi-isolant, d'une part les régions d'accès, dites source et drain, et d'autre part, une région de commande constituée par une couche active en GaAs faiblement dopée et en juxtaposition avec une couche en $Al_xGa_{1-x}As$. Ces transistors possèdent tous la particularité de présenter une forte accumulation d'électrons dans la couche de GaAs du fait de l'existence de l'hétérojonction et une forte mobilité d'électrons dans le canal du transistor, entre source et drain, du fait du faible dopage de la couche active en GaAs. Ainsi ces transistors ont une fréquence de coupure élevée. (Les documents de la demanderesse cités dans la présente demande ont été publiés après la date de priorité revendiquée dans la présente demande et font donc partie de l'état de la technique selon l'article 54B) C.B.E). Dans les documents EP-A 0 017 531 et ET-A 0 027 761, de la demanderesse, une couche d'isolant est intercalée entre le métal de contact de grille et la couche en $Al_xGa_{1-x}As$. Dans le document EP-A 0 025 742, de la demanderesse, le contact de grille Schottky est déposé sur une couche en GaAs, la couche en $Al_xGa_{1-x}As$ étant située entre le substrat semi-isolant et la couche active en GaAs.

Ces transistors ne concernent que des couches actives en GaAs. Il existe dans la famille des composés semiconducteurs III–V, des matériaux ayant une plus forte mobilité que GaAs: ce sont par exemple In As, In Sb ou leurs alliages du type $Ga_xIn_{1-x}As$ ou $In As_x Sb_{1-x}$. A la température ambiante ces matériaux, s'ils sont faiblement dopés, ont respectivement pour mobilité 20 000, 80 000, 15 000 et 50 000 $cm^2 v^{-1} s^{-1}$. Les deux dernières valeurs correspondent à des compositions telles que $x \simeq 0,5$. A titre de comparaison, GaAs faiblement dopé a une mobilité de 8000 $cm^2 v^{-1} s^{-1}$. Il est alors intéressant d'utiliser ces matériaux comme partie active du canal d'un transistor à effet de champ.

Des transistors à effet de champ en $Ga_xIn_{1-x}As$ ont été déjà décrits dans la littérature. Il s'agit des transistors MESFET (Metal Schottky field effect transistor) ou à jonction (JFET) dans lesquels la couche active est dopée à $10^{17}$ atomes/$cm^3$ environ et dans lesquels la mobilité électronique est voisine de 10 000 $cm^2 v^{-1}s^{-1}$. Pour atteindre une mobilité de 15 000 $cm^2 v^{-1}s^{-1}$ il faut utiliser $Ga_x In_{1-x}As$ faiblement dopé selon des structures à hétérojonction décrites dans les documents EP-A 0 017 531, EP-A 0 025 742 et EP-A 0 027 761, de la demanderesse.

Cependant ces semiconducteurs connus ont des bandes interdites de faible largeur, ce qui entraîne les difficultés suivantes:
- pour ceux qui utilisent InAs, InSb et les alliages $InAs_{1-x}Sb_x$, les bandes interdites sont si faibles (de 0,23 à 0,41 eV), qu'il est exclu de travailler à la température ambiante. A basse température (77°K) l'avantage de la forte mobilité par rapport à GaAs n'est plus valable. De ce point de vue, InAs, InSb et $InAs_{1-y}Sb_x$ ne présentent pas d'intérêt, mais $Ga_xIn_{1-x}As$ reste intéressant.
- les grilles Schottky déposées sur ces matériaux présentent des courants de fuite élevés. Ce qui exclut son utilisation selon l'une des structures décrites dans le document EP-A 0 025 742.

L'objet de la présente invention est de remédier à ces limitations par une structure particulière de canal de transistor à effet de champ, ce canal comprenant, outre la grille Schottky, une hétérojonction formée entre un premier matériau semiconducteur tel que $Ga_xIn_{1-x}As$ et un second matériau semiconducteur, de la famille des composés III–V ayant même paramètre de maille cristalline que $Ga_xIn_{1-x}As$ mais de bande interdite plus grande, le couple de matériaux formant ainsi une hétérojonction N–N et présentant une couche d'accumulation d'électrons dans $Ga_xIn_{1-x}As$.

De façon plus précise, l'invention consiste en un transistor à effet de champ à fréquence de coupure élevée, comportant, supportées par un substrat semi-isolant, deux régions d'accès dites de source et de drain et une région de commande composée d'une première couche active, d'une seconde couche et d'une grille métallique dite de Schottky, la seconde couche étant située entre la première couche et la grille métallique, ce transistor étant caractérisé en ce que la première couche, d'un matériau semiconducteur d'une seconde famille forment une hétérojonction isotype N–N, dans laquelle le matériau semiconducteur de seconde famille possède le même paramètre de maille cristalline et une bande interdite plus grande que le matériau semiconducteur de première famille, et en ce que la première couche est dopée à un niveau inférieur, ou égal, à $10^{16}$ atomes/$cm^3$ et la seconde couche est dopée à un niveau supérieur, ou égal, à $10^{17}$ atomes/$cm^3$.

L'invention sera mieux comprise par la description qui suit, laquelle s'appuie sur des exemples de réalisation et sur les figures parmi lesquelles:

la figure 1 représente le schéma de bandes à l'équilibre, d'une hétérojonction comportant un semiconducteur à petite bande interdite, un semiconducteur à grande bande interdite et un métal;

la figure 2 représente le schéma de bandes de l'hétérostructure sous polarisation négative du côté métal;

la figure 3 représente en coupe schématique, un premier exemple de transistor selon l'invention;

la figure 4 représente en coupe schématique, un deuxième exemple de transistor selon l'invention;

la figure 5 représente en coupe schématique, un troisième exemple de transistor selon l'invention;

la figure 6 représente en coupe schématique, un quatrième exemple de transistor selon l'invention.

La notion d'accumulation d'électrons à l'interface d'une hétérojonction entre deux couches de matériaux, l'un ayant une hauteur de barrière interdite plus grande que l'autre, est connue depuis les travaux théoriques de Anderson sur les hété- rojonctions et de Dingle sur les super-réseaux d'hétérojonctions.

A la différence du couple de matériaux Ga/ GaAs où des difficultés d'ordre technologique et peut être de physique, font que l'interface est de qualité médiocre et porteur d'une charge négative fixe importante, le couple GaAs/Al$_x$Ga$_{1-x}$As semble se comporter de façon quasi idéale. La présence d'éventuels pièges ou centres de recombinaison à l'interface n'a pu être révélée et la transiton peut être très abrupte. De plus l'absence de charge négative d'interface autorise, dans les structures proposées, l'existence d'une couche d'accumulation électronique côté GaAs. L'hétérojonction satisfait alors au modèle proposé par Anderson dans un article intitulé «germanium gallium arsenide heterojonctions» (IBM journal, juillet 1960, pages 283–287). Cette propriété a été vérifiée par DINGLE et ses collaborateurs dans un article intitulé «Electron mobilities in modulation doped semiconductor heterojonctions superlattice» [App. Phys. lett vol 33, N° 7, p. 665 (1968)], sur une structure «super-réseau» constituée par un empilement régulier de couches alternativement de GaAs non intentionnellement dopé et de Al$_x$Ga$_{1-x}$As dopé N. Il a mis en évidence, dans les puits de potentiel GaAs, une forte concentration électronique et mesuré une mobilité excellente proche de la mobilité du matériau GaAs non intentionnellement dopé. Il est très douteux qu'il s'agisse là d'un effet spécifique du super-réseau. Il s'agit plutôt d'une propriété des couches d'accumulation prédites par Anderson et localisées dans GaAs à chaque interface. Le brevet EP-A-0 005 059 de Dingle et ses collaborateurs, revendiquant une priorité du 24 avril 1978, décrit un transistor dont la couche active est constituée par un super-réseau, comportant un grand nombre d'hétérojonctions.

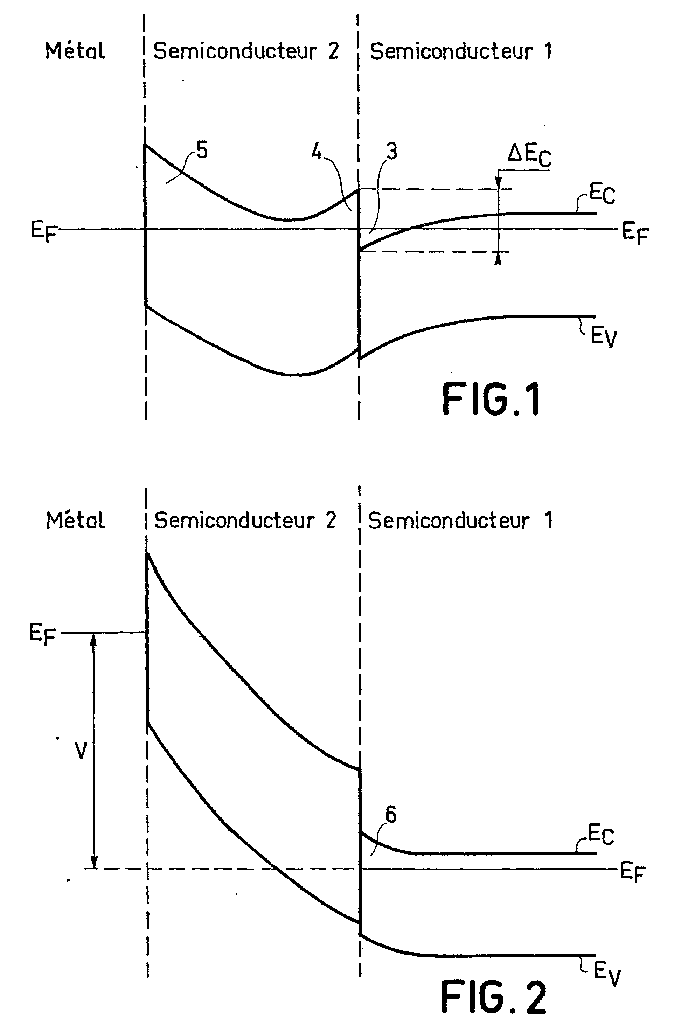

La figure 1 représente une hétérostructure composé, d'une part, d'une hétérojonction isotype formée d'un premier semiconducteur 1 de type N et d'un second semiconducteur 2 de type N également, ayant une bande interdite plus grande que le premier semiconducteur 1 mais présentant le même paramètre de maille que ce dernier et, d'autre part, d'un contact Schottky formé entre un métal et le second semiconducteur 2. Sur la figure 1, le système est à l'équilibre, c'est-à-dire que les niveaux Fermi E$_F$ sont alignés.

E$_c$ et E$_v$ représentent respectivement les niveaux d'énergie de la bande de conduction et de valence, et $\Delta$E$_c$ représente la discontinuité dans la bande de conduction. Comme il a été déjà décrit dans les documents EP-A 0 017 531 et EP-A 0 025 742 de la demanderesse, il existe à l'interface de l'hétérojonction une zone d'accumulation d'électrons du côté du semiconducteur 1 à petite bande interdite, et une couche de désertion d'électrons 4 du côté du semiconducteur 2 à grande bande interdite. Le semiconducteur 1 étant faiblement dopé, la mobilité des électrons dans la zone 3 est élevée. A l'interface métal-semiconducteur 2 il existe une zone 5 de désertion d'électrons.

Sur la figure 2, le système est soumis à une tension V négative sur le métal. Pour une tension V suffisamment grande en valeur absolue, la région 5 de charge d'espace s'étend jusqu'à l'interface de l'hétérojonction, détruisant ainsi la couche d'accumulation 3 pour laisser apparaître une zone 6 désertée d'électrons.

Dans le cas précis où le semiconducteur 1 est Ga$_x$In$_{1-x}$As, sa composition se doit être telle que son paramètre de maille soit adapté à un substrat connu de façon à obtenir une couche épitaxiale de bonnes qualités. Les substrats en GaAs ou InAs étant évidemment exceptés puisque leur paramètre de maille est différent de celui de Ga$_x$In$_{1-x}$As. Pour x $\simeq$ 0,5 l'alliage Ga$_x$In$_{1-x}$As est adapté en paramètre de maille avec InP. L'alliage Ga$_x$In$_{1-x}$As a pour bande interdite environ 0,75 eV pour x $\simeq$ 0,5. Le semiconducteur 2 à bande interdite plus grande que Ga$_x$In$_{1-x}$As peut être donc InP, (bande interdite 1,36 eV) Al$_x$In$_{1-x}$As (x $\simeq$ 0,5) (bande interdite 1,46 eV), GaAs$_y$Sb$_{1-y}$ (y $\simeq$ 0,5), AlAs$_y$Sb$_{1-y}$ (y $\simeq$ 0,5) ou des alliages quaternaires Ga$_x$In$_{1-x}$As$_y$P$_{1-y}$, Al$_x$Ga$_{1-x}$As$_y$Sb$_{1-y}$. On conviendra d'appeler ces semiconducteurs à grande bande interdite, semiconducteurs 2.

On conviendra également, dans le seul souci de simplification du texte qui suit, d'écrire GaInAs au lieu de Ga$_x$In$_{1-x}$As.

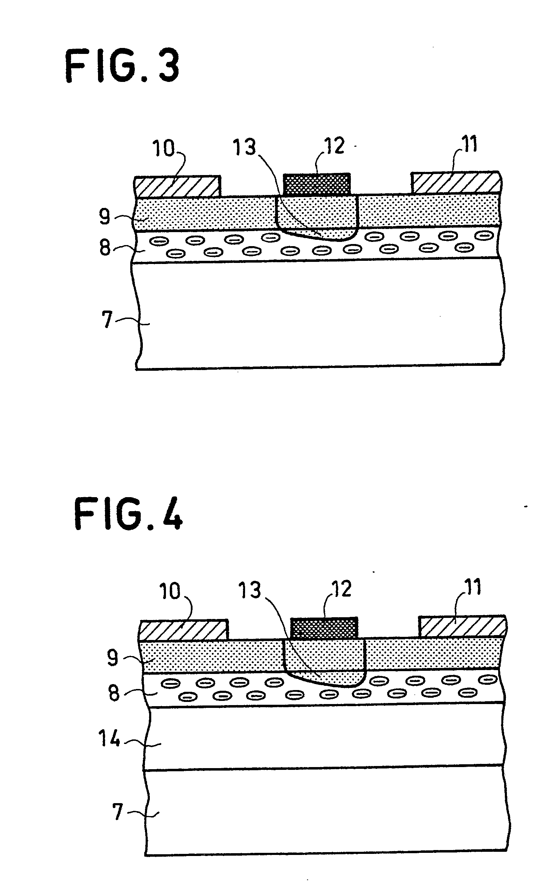

La figure 3 représente en coupe schématique, le premier exemple de transistor selon l'invention.

Sur un substrat 7, en InP par exemple, semi-isolant, sont déposées par épitaxie successivement une couche 8 en GaInAs et une couche 9 constituée d'un semiconducteur 2. La couche 8 est faiblement dopée à un niveau inférieur à 10$^{16}$ atomes/cm$^3$ et la couche 9 est dopée à un niveau supérieur à 10$^{17}$ atomes/cm$^3$. Les électrodes 10 de source et 11 de drain sont déposées de part et d'autre de l'électrode 12 de grille Schottky. Comme il a la couche 8 de GaInAs et désertent la couche 9. Afin que seuls les électrons de la zone d'accumulation interviennent dans le fonctionnement du transistor, l'épaisseur de la couche 8 est égale à l'épaisseur de la zone d'accumulation (environ 0,1 µm) et celle de la couche 9 égale à l'épaisseur de la zone désertée (environ 0,1 µm). La modulation du courant source-drain se fait par l'intermédiaire de la polarisation de grille.

Le transistor décrit fonctionne à haute fréquence selon le fondement de l'invention.

Cependant, il est connu que l'interface entre un substrat semi-isolant et une couche active contient des défauts électriquement actifs. Il est donc avantageux d'intercaler entre le substrat 7 et la couche 8 de GaInAs une couche épitaxiale de haute résistivité appelée couche tampon, de façon à supprimer ces défauts locaux.

La figure 4 représente un deuxième exemple de transistor, doté d'un premier perfectionnement, selon l'invention.

Sa structure possède en plus de ce qui a été décrit dans l'exemple précédent, une couche tampon 14 en InP de haute résistivité ou en semiconducteur 2 de haute résistivité, intercalée entre le substrat 7 en InP semi-isolant et la couche active 8.

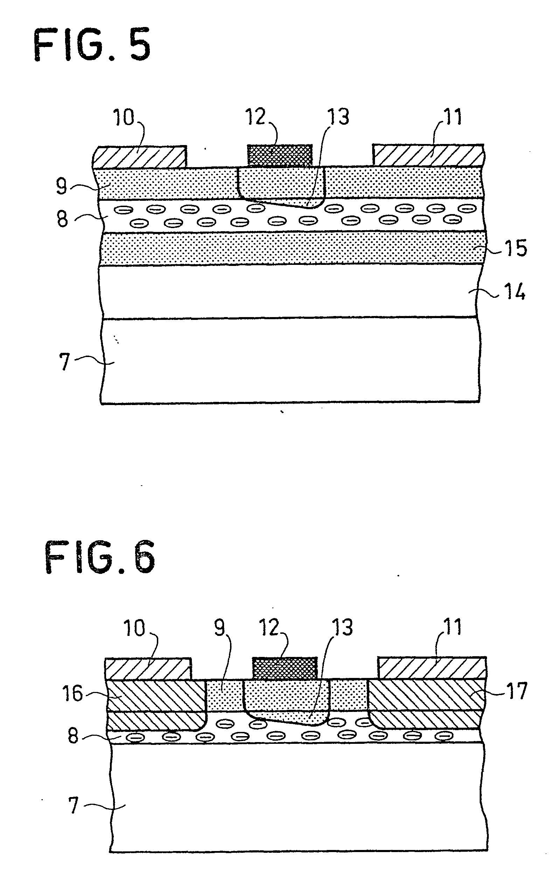

La figure 5 représente un troisième exemple de transistor doté d'un second perfectionnement selon l'invention.

Ce transistor comporte en plus des éléments décrits dans le second exemple, une couche 15 en semiconducteur 2 intercalé entre la couche active 8 et la couche tampon 14. La couche 15 est dopée de type N à un niveau supérieur à $10^{17}$ atomes/cm³ afin d'accroître la densité d'électrons accumulés dans la couche 8 en GaInAs. On augmente ainsi la transconductance du dispositif. L'épaisseur de la couche 15 est égale à l'épaisseur de la zone désertée d'électrons dans l'hétérojonction (environ 0,1 μm).

Dans les structures décrites précédemment, les contacts ohmiques 10 de source et 11 de drain sont déposés sur le semiconducteur 2. Or il existe une barrière de potentiel $\Delta E_c$ que les électrons doivent franchir pour aller de la source au drain. En général $\Delta E_c$ est suffisamment faible pour que les électrons puissent la franchir, cependant cette barrière diminue la conductance source-drain.

Afin d'accroître cette conductance, la hauteur apparente de barrière d'hétérojonction est réduite par effet tunnel en dopant fortement le semiconducteur 2, dans les régions situées sous la source et le drain.

La figure 6 représente une telle structure dans laquelle les caissons 16 et 17 situés sous les contacts, fortement dopés (supérieurs à $10^{18}$ atomes/cm³), sont obtenus par implantations avant dépôt des contacts 10 et 11. Pour être pleinement efficaces, il faut que les caissons 16 et 17 pénètrent dans la couche active 8. Les caissons 16 et 17 permettent en plus de réduire les résistances de contact de source et de drain et les résistances séries constituées par l'épaisseur de la couche 9 sous la source et le drain.

Les structures représentées dans les trois premiers exemples sont améliorées par l'adjonction des caissons 16 et 17, sous les contacts des régions d'accès.

Dans les exemples de réalisation décrits, le substrat est constitué par InP. Cependant, appartiennent au domaine de l'invention les autres substrats, et les autres couches semiconductrices cités dans le texte à l'occasion de la figure 2, alliages ternaires et quaternaires, et qui sont précisés dans les revendications ci-après.

Les transistors selon l'invention trouvent leurs applications dans tous les domaines hyperfréquences, notamment les télécommunications.

**Revendications**

1. Transistor à effet de champ à fréquence de coupure élevée, comportant, supportées par un substrat semi-isolant (7), deux régions d'accès dites de source (10) et de drain (11) et une région de commande composée d'une première couche active (8), d'une seconde couche (9) et d'une grille métallique (12) dite de Schottky, la seconde couche (9) étant située entre la première couche (8) et la grille métallique (12), ce transistor étant caractérisé en ce que le matériau semiconducteur de la première couche (8), dopé à un niveau inférieur ou égal à $10^{16}$ at/cm³ et de petite bande interdite, forme avec le matériau semiconducteur de la seconde couche (9), dopé à un niveau supérieur ou égal à $10^{17}$ at/cm³ et de bande interdite plus grande que celle du matériau de la première couche (8), une hétérojonction isotype n–n à l'interface de laquelle se forme une zone d'accumulation d'électrons, du côté du semiconducteur à petite bande interdite (8), et une zone de désertion d'électrons, du côté du semiconducteur à grande bande interdite (9), l'épaisseur de la première couche (8) étant égale à l'épaisseur de la zone d'accumulation ($\simeq 0,1$ μm) et celle de la seconde couche (9) égale à l'épaisseur de la zone de désertion ($\simeq 0,1$ μm), les matériaux semiconducteurs des deux couches (8, 9) ayant en outre même paramètre de maille cristalline.

2. Transistor à effet de champ selon la revendication 1, caractérisé en ce que:
– le substrat semi-isolant (7) est constitué par InP;
– le premier semiconducteur de la première couche (8) est $Ga_xIn_{1-x}As (x \simeq 0,5)$;
– le second semiconducteur de la seconde couche (9) est choisi parmi InP, $Al_xIn_{1-x}As$ ($x \simeq 0,5$), $AlAs_ySb_{1-y}$ ($y \simeq 0,5$) ou l'un des alliages quaternaires $Ga_xIn_{1-x}As_yP_{1-y}$, $Al_xGa_{1-x}As_ySb_{1-y}$.

3. Transistor à effet de champ selon la revendication 1, caractérisé en ce que:
– le substrat semi-isolant (7) est constitué par GaAs;
– le premier semiconducteur de la première couche (8) est GaAs;
– le second semiconducteur de la seconde couche (9) est $Al_xGa_{1-x}As$, avec $0,1 \leqslant x \leqslant 0,8$.

4. Transistor à effet de champ selon la revendication 1, caractérisé en ce qu'une couche tampon (14) du second semiconducteur de haute résistivité est située entre la première couche (8) et le substrat semi-isolant (7).

5. Transistor à effet de champ selon la revendication 4, caractérisé en ce qu'une troisième couche (15) de second semiconducteur dopée à un niveau supérieur à $10^{17}$ atomes/cm³ est située entre la couche tampon (14) et la première couche (8).

6. Transistor à effet de champ selon l'une quelconque des revendications de 1 à 5, caractérisé en ce qu'il comporte deux caissons (16 et 17) dopés à un niveau supérieur à $10^{18}$ atomes/cm³, situés sous les contacts de source (10) et de drain (11), ces caissons ayant une épaisseur au moins égale à l'épaisseur de la seconde couche (9), et au plus égale à l'épaisseur totale des première (8) et seconde (9) couches.

**Claims**

1. A field effect transistor having a high cut-off frequency and comprising on a semi-insulating substrate (7) two access regiones called source region (10) and drain region (11) and a control region composed of a first active layer (8), a second layer (9) and a metal gate (12) called Schottsky-gate the second layer (9) being situated between the first layer (8) and the metal gate (12), characterized in that the semiconductor material of the first layer (8) which is doped at a rate of up to $10^{16}$ atoms per $cm^3$ and which has a small forbidden band, constitutes together with the semiconductor material of the second layer (9), which is doped with at least $10^{17}$ atoms per $cm^3$ and which has a larger forbidden band than the material of the first layer (8), an isotype n–n heterojunction, at the interface of which an electron accumulation zone on the side turned to the semiconductor with a small forbidden band (8) is formed, whereas an electron depletion zone is formed on the side turned towards the semiconductor with a large forbidden band (9), the thickness fo the first layer (8) being equal to the thickness of the accumulation zone (about 0,1 µm) and the thickness of the second layer (9) being equal to the thickness of the depletion zone (about 0,1 µm), the semiconductor materials of the two layers (8, 9) presenting moreover the same cristal lattice parameter.

2. A field effect transistor according to claim 1, characterized in that:
– the semi-insulating substrate (7) is constituted of InP;
– the first semiconductor of the first layer (8) is consituted of $Ga_xIn_{1-x}As$, with x about 0,5;
– the second semiconductor of the second layer (9) is chosen from InP, $Al_xIn_{1-x}As(x \simeq 0,5)$, $AlAs_ySb_{1-y}(y \simeq 0,5)$, or from one of the quaternary alloys $Ga_xIn_{1-x}As_yP_{1-y}$, $Al_xGa_{1-x}As_ySb_{1-y}$.

3. A field effect transistor according to claim 1, characterized in that:
– the semi-insulating substrate (7) is constituted of GaAs;
– the first semiconductor of the first layer (8) is constituted by GaAs;
– the second semiconductor of the second layer (9) is constituted by $Al_xGa_{1-x}As$, with $0,1 \simeq x \leqslant 0,8$.

4. A field effect transistor according to claim 1, characterized in that a buffer layer (14) of the second semiconductor of high resistivity is situated between the first layer (8) ant the semi-insulating substrate (7).

5. A field effect transistor according to claim 1, characterized in that a third layer (15) of the second semiconductor doped with more than $10^{17}$ atoms per $cm^3$ is situated between the buffer layer (14) and the first layer (8).

6. A field effect transistor according to any one of claims 1 to 5, characterized in that it comprises two pots (16 and 17) doped with more than $10^{18}$ atoms per $cm^3$ and situated under the source and drain contacts (10 and 11 respectively), these pots having a thickness which is at least equal to the thickness fo the second layer (9) and at the most equal to the total thickness of the first and second layers (8 and 9 respectively).

**Patentansprüche**

1. Feldeffekttransistor mit hoher oberer Grenzfrequenz, der auf einem halbisolierenden Substrat (7) zwei Zugangszonen, nämlich eine Quellenzone (10) und eine Drainzone (11), sowie eine Steuerzone aufweist, die sich aus einer ersten aktiven Schicht (8), einer zweiten Schicht (9) und einem sogenannten Schottky-Metallgate (12) zusammensetzt, wobei die zweite Schicht (9) zwischen der ersten Schicht (8) und dem Metallgate (12) liegt, dadurch gekennzeichnet, dass das Halbleitermaterial der ersten Schicht (8), das mit höchstens $10^{16}$ Atomen pro $cm^3$ dotiert ist und ein schmales verbotenes Band besitzt, mit dem Halbleitermaterial der zweiten Schicht (9), das mit mindestens $10^{17}$ Atomen pro $cm^3$ dotiert ist und ein breiteres verbotenes Band als die erste Schicht (8) besitzt, eine n–n Isotyp-Heterojunktion bildet, an deren Zwischenfläche sich eine Elektronenansammlungszone auf der Seite des Halbleiters mit schmalem verbotenen Band (8) und eine Elektronenverarmungszone auf der Seite des Halbleiters mit breitem verbotenen Band (9) bildet, wobei die Dicke der ersten Schicht (8) gleich der der Elektronenansammlungszone ist ($\simeq$ 0,1 µm) und die Dicke der zweiten Schicht (9) gleich der der Verarmungszone ist ($\simeq$ 0,1 µm) und wobei die beiden Schichten (8, 9) weiter gleiche Kristallgitterparameter besitzen.

2. Feldeffekttransistor nach Anspruch 1, dadurch gekennzeichnet, dass :
– das halbisolierende Substrat (7) aus InP besteht;
– der erste Halbleiter der ersten Schicht (8) aus $Ga_xIn_{1-x}As$ is, wobei x etwa 0,5 gewählt wird;
– der zweite Halbleiter der zweiten Schicht (9) unter den folgenden Stoffen ausgewählt wird: InP, $Al_xIn_{1-x}As$ (mit $x \simeq 0,5$), $AlAs_ySb_{1-y}(y \simeq 0,5)$ oder eine der quaternären Legierungen $Ga_xIn_{1-x}As_yP_{1-y}$, $Al_xGa_{1-x}As_ySb_{1-y}$.

3. Feldeffekttransistor nach Anspruch 1, dadurch gekennzeichnet, dass :
– das halbisolierende Substrat (7) aus GaAs besteht;
– der erste Halbleiter der ersten Schicht (8) aus GaAs besteht;
– der zweite Halbleiter der zweiten Schicht (9) aus $Al_xGa_{1-x}As$ besteht, wobei $0,1 \leqslant x \leqslant 0,8$ gilt.

4. Feldeffekttransistor nach Anspruch 1, dadurch gekennzeichnet, dass eine Pufferschicht (14) des zweiten Halbleiters mit hohem spezifischen Widerstand zwischen der ersten Schicht (8) und dem halbisolierenden Substrat (7) angeordnet ist.

5. Feldeffekttransistor nach Anspruch 4, dadurch gekennzeichnet, dass eine dritte Schicht (15) des zweiten Halbleiters, die mit mehr als $10^{17}$ Atomen pro $cm^3$ dotiert ist, zwischen der Pufferschicht (14) und der ersten Schicht (8) liegt.

6. Feldeffekttransistor nach einem beliebigen der Ansprüche 1 bis 5, dadurch gekennzeichnet, dass er zwei Kästen (16 und 17) enthält, die mit mehr als $10^{18}$ Atomen pro $cm^3$ dotiert sind und unter den Quellen- und Drainkontakten (10 bzw. 11) liegen, wobei diese Kästen eine Dicke besitzen, die mindestens gleich der der zweiten Schicht (9) und höchstens gleich der Gesamtdicke der ersten (8) und zweiten Schicht (9) ist.

FIG.1

FIG.2

# FIG. 3

# FIG. 4

# FIG. 5

# FIG. 6